# EUROPEAN PATENT APPLICATION

(11) **EP 1 740 028 A1**
(43) Date of publication of application: **03.01.2007**
(21) Application number: 05460017.6
(22) Date of filing: 28.06.2005
(51) Int. Cl.: H05K 3/34, H01R 13/646, H01R 13/658

(54) **Printed circuit board with RF connector and method for attaching RF connector to printed circuit board**

(71) Applicant: ADVANCED DIGITAL BROADCAST S.A., 1218 Grand-Saconnex (CH)
(72) Inventor: Cichonski, Dariusz, 65-001 Zielona Gora (PL)
(74) Representative: Hudy, Ludwik

(57) **Abstract**

A printed circuit board with an RF connector (210) and an RF signal processing circuit (203), the connector (210) having a signal wire (214) for through-hole mounting shielded with a connector shield (212) characterized in that the connector (210) is mounted to the printed circuit board (200) on a top layer (201) such that the signal wire (214) is inserted in a hole in the printed circuit board (200) and an ending (217) of the signal wire (214) extends above a bottom layer (202) of the printed circuit board (200) to which it is soldered, the RF signal processing circuit (203) is mounted on the bottom layer (202) of the printed circuit board (200) and connected to the ending (217) of the signal wire (214) via a RF signal path (219) placed on the bottom layer (202) of the printed circuit board (200), and that a shield (221) is mounted on the bottom layer (202) and encompasses the RF signal processing circuit (203), the ending (217) of the signal wire (214) and the RF signal path (219).

## Description

The invention relates to a printed circuit board with an RF connector, and a method for attaching an RF connector to the printed circuit board.

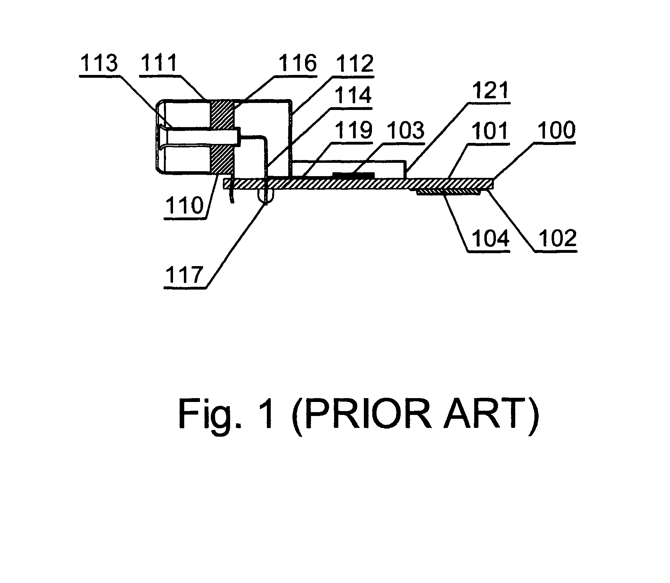

A popular interface for connecting an antenna cable to a radio or television signal receivers is a radio frequency signal (RF) connector 110 as shown in Fig. 1. The RF connector 110 is usually mounted on a top layer 101 of a printed circuit board 100 and attached to it by means of a connector shield 112. The RF connector 110 has a cylindrical metallic portion 113 held centrally in an outer part 111 of the RF connector 110 by means of an insulating insert 116. The cylindrical metallic portion 113 is connected to an RF signal processing circuit via a signal wire 114 inserted in a hole made in the printed circuit board 100. The signal wire 114 extends above a bottom layer 102 and its ending 117 is soldered to the bottom layer, to which a bottom chip 104 is connected. An RF signal path 119 placed on the top layer 101 transmits the RF signal from the signal wire 114 to the RF signal processing circuit. The RF signal processing circuit may be a tuner chip 103. The tuner chip 103 is, together with the RF signal path 119, shielded by means of a tuner chip shield 121 situated on the top layer 101 of the printed circuit board 100. Such shielding is insufficient because the ending 117 is unshielded and acts as an antenna, which receives interferences disturbing the RF signal to be delivered to the RF signal processing circuit.

An RF connector having a signal wire, which is a through-hole mounted connector, is known from the US Patent No. 6,140,977 entitled *"Method for attaching an antenna to a circuit board and article produced thereby".* An outer part of this connector is placed in a slot made in a circuit board and soldered to metallized edges of the slot to form a first solder joint therebetween. A second solder joint is formed between the signal wire (called a finger) and a hole via which the finger extends. A signal path is placed on the circuit board layer opposite to the layer above which the finger ending extends. Therefore, to avoid interferences, shields should be attached both to a bottom layer and a top layer of the circuit board.

From the European Patent Application No. EP 1 246 517 A2 entitled *"Tuner for mounting on a circuit board"* there is known a threaded coaxial RF connector, which has a threaded portion and a flanged portion, and is attached to a frame by swaging. A center conductor of the connector is connected to the circuit board in a way other than through-hole mounting, for example by bending the ending and soldering it to the top layer of the board. Therefore, in such configuration the problem of shielding the ending of the connector extending above the opposite layer of the board does not exist. However, the method of soldering the connector to the circuit board may be in some production processes more complicated and more costly than through-hole mounting.

It is therefore an object of the present invention to provide a printed circuit board with an RF connector having a through-hole mounted signal wire, where the RF signal path from the connector to the RF signal processing circuits is effectively shielded by a less complicated shielding arrangement than the shielding arrangement required by configurations known from prior art.

The object of the present invention is achieved with a printed circuit board with an RF connector and an RF signal processing circuit, the connector having a signal wire for through-hole mounting shielded with a radio-frequency connector shield, characterized in that the connector is mounted to the printed circuit board on a top layer such that the signal wire is inserted in a hole in the printed circuit board and an ending of the signal wire extends above a bottom layer of the printed circuit board to which it is soldered, the RF signal processing circuit is mounted on the bottom layer of the printed circuit board and connected to the ending of the signal wire via a RF signal path placed on the bottom layer of the printed circuit board, and that a shield, is mounted on the bottom layer and encompasses the RF signal processing circuit, the ending of the signal wire and the RF signal path.

In a preferred embodiment, the tuner shield is a two-part rectangular prism shaped box.

It is of special advantage that the tuner shield is made of a diamagnetic material.

Preferably, the tuner shield and/or the circuit board have holes to allow air circulation.

The signal processing circuit may include a tuner chip.

Preferably, the shield and the connector shield are connected to a common ground plane.

According to the present invention there is provided a method for attaching an RF connector to a printed circuit board comprising the steps of making a printed circuit board, attaching the RF connector to a first layer of the printed circuit board such that a signal wire of the connector extends via a hole above a bottom layer of the printed circuit board, soldering the signal wire of the RF connector to an RF signal path on the bottom layer of the printed circuit board, placing an RF signal processing circuit on the bottom layer, mounting a shield on the bottom layer of the printed circuit board to encompass the RF signal processing circuit, the ending of the signal wire and the RF signal path.

The invention will now be described by way of example and with reference to the accompanying drawings in which:
Fig. 1 shows a cross-section view of a printed circuit board with an RF connector and shielding configuration known from prior art;
Fig. 2 shows an enlarged perspective view of a printed circuit board with an RF connector;
Fig. 3 shows a front view of the printed circuit board with the RF connector shown in Fig. 2;
Fig. 4 shows a cross-section view of the printed circuit board taken along line A-A shown in Fig. 3;
Fig. 5 shows a top view of the printed circuit board shown in Fig. 3;
Fig. 6 shows a bottom view of a printed circuit board shown in Fig. 3;
Fig. 7 shows a cross-section view of the printed circuit board taken according to line B-B shown in Fig. 6; and
Fig. 8 shows a left side view of the printed circuit board shown in Fig. 3.

The invention will be described in detail with reference to a printed circuit board with an RF connector, suitable for radio and television signal receivers.

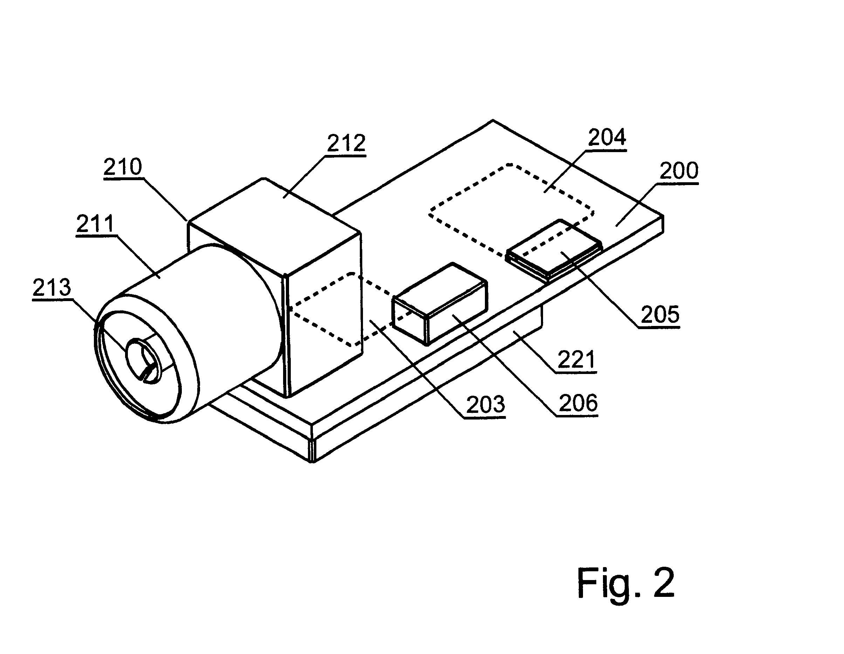

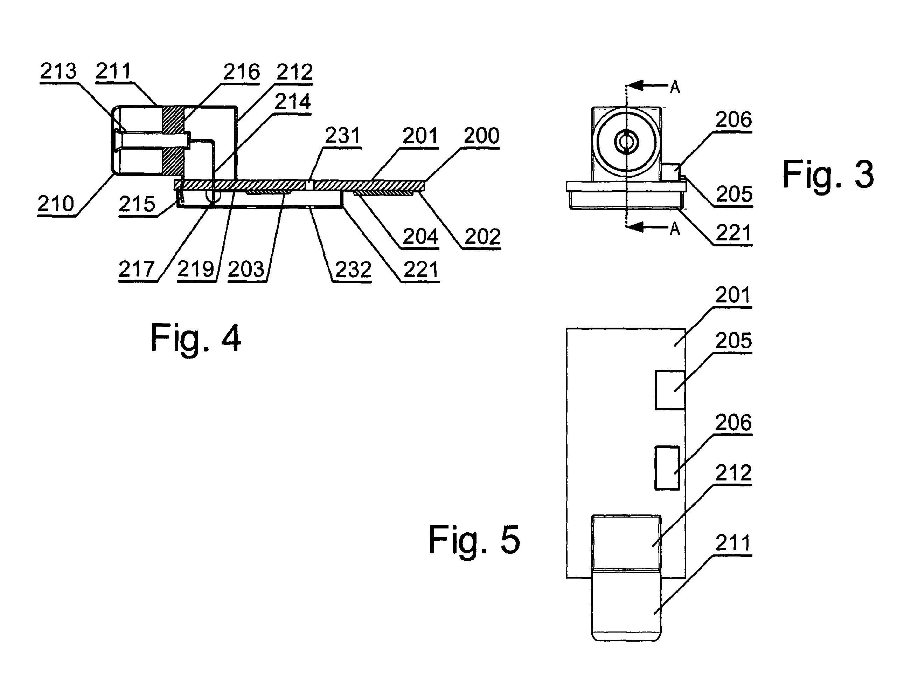

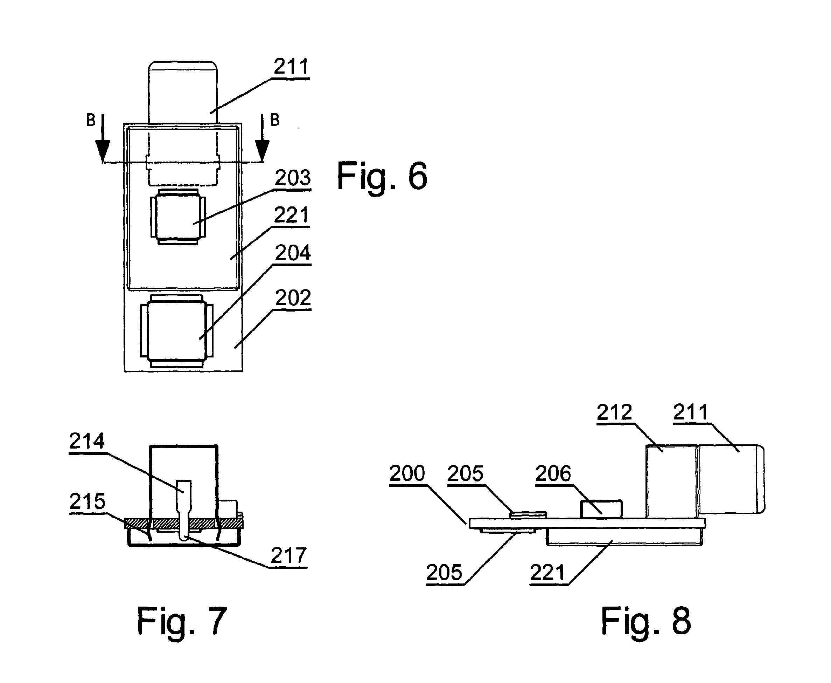

A printed circuit board 200, shown in Figs. 2 - 8, is equipped with an RF connector 210, which has an outer cylindrical shielding part 211, a cylindrical metallic signal input portion 213 supported centrally in the outer part 211 by means of an insulating insert 216. The signal input portion expands into a signal wire 214 shielded with the RF connector shield 212 joined with the outer part 211 and mounted to the board 200 by protrusions 215. The protrusions may be soldered to a ground plane, making the connector shield 212 and the outer part 211 grounded and providing shielding for the RF signal within the enclosure of the RF connector 210. The RF connector 210 is mounted on a top layer 201. The signal wire 214 is mounted in a hole made in the printed circuit board 200. The signal wire 214 extends above a bottom layer 202, and its ending 217 is soldered to the hole. An RF signal path 219 situated on the bottom layer 202 is in contact with the hole and transmits the RF signal to RF signal processing circuit 203, for example a tuner chip, placed on the bottom layer 202. The RF signal processing circuit 203 may comprise several elements, for example a tuner chip and its input circuits including splitters, diplexers, filters or ESD protection elements. The RF signal processing circuit 203 together with the RF signal path 219 are shielded by a shield 221 made of a diamagnetic material and mounted on the bottom layer 202 of the printed circuit board 200. The shield 221 can be two-part rectangular prism shaped box with the first (base) part mounted on the bottom layer 202 and the second part (lid) mechanically attachable to the first part. By encompassing the ending 217 of the signal wire 214, the shield 221 provides a complete shielding for the RF signal path from the RF connector 210 to the RF signal processing circuit 203, and therefore prevents receiving external noise, which could interfere with the received RF signal.

The signal processed by the RF signal processing circuit is transmitted to other circuits 204, 205 or 206 placed on the top 201 or bottom layer 202 of the printed circuit board 200. Such circuits may include demodulators, signal processors and other elements.

The tuner shield 221 and/or the circuit board 200 can have holes 232, 231 to allow air circulation. The cross section of the holes should be small enough, not to allow interferences entering the enclosure of the shield 221.

The advantage of the present solution is that the single shield 221 placed on the bottom layer 202 of the printed circuit board 200 encompassing the RF signal processing circuit 203, the RF signal path 219 and the ending 217 of the signal wire 214 provides effective shielding for the received RF signal. During manufacture of the printed circuit board with the connector according to the present invention, first, the RF connector 210 is attached to the first layer 201 of the printed circuit board 200 in such way that the signal wire 214 of the RF connector extends via the hole above the bottom layer 202 of the printed circuit board 200. Next, the signal wire 214 of the RF connector is soldered to the RF signal path 219 on the bottom layer 202 of the printed circuit board 200. Then, the RF signal processing circuit 203 is placed on the bottom layer 202. Finally, the shield 221 is mounted on the bottom layer 202 of the printed circuit board 200 to encompass the RF signal processing circuit 203, the ending of the signal wire 217 and the RF signal path 219. Clearly, the manufacture of a single shield instead of two shields necessary to achieve the same result in the known configurations is advantageous and more efficient.

## Claims

1. A printed circuit board with an RF connector (210) and an RF signal processing circuit (203), the connector (210) having a signal wire (214) for through-hole mounting shielded with a connector shield (212) **characterized in that** the connector (210) is mounted to the printed circuit board (200) on a top layer (201) such that the signal wire (214) is inserted in a hole made in the printed circuit board (200) and an ending (217) of the signal wire (214) extends above a bottom layer (202) of the printed circuit board (200) to which it is soldered, the RF signal processing circuit (203) is mounted on the bottom layer (202) of the printed circuit board (200) and connected to the ending (217) of the signal wire (214) via a RF signal path (219) placed on the bottom layer (202) of the printed circuit board (200), and that a shield (221) is mounted on the bottom layer (202) and encompasses the RF signal processing circuit (203), the ending (217) of the signal wire (214) and the RF signal path (219).

2. The printed circuit board, according to claim 1, **characterized in that** the tuner shield (221) is a two-part rectangular prism shaped box.

3. The printed circuit board, according to claim 1, **characterized in that** the tuner shield (221) is made of diamagnetic material.

4. The printed circuit board, according to claim 1, **characterized in that** the tuner shield (221) and/or the circuit board (200) have holes to allow air circulation (232, 231).

5. The printed circuit board according to claim 1, **characterized in that** the RF signal processing circuit (203) includes a tuner chip.

6. The printed circuit board according to claim 1, **characterized in that** the shield (221) and the connector shield (212) are connected to a common ground plane.

7. A method for attaching an RF connector (210) to a printed circuit board (200) comprising the steps of:
making a printed circuit board (200);
attaching the RF connector (210) to a first layer (201) of the printed circuit board (200) such that a signal wire (214) of the RF connector extends via a hole above a bottom layer (202) of the printed circuit board (200);
soldering the signal wire (214) of the RF connector to an RF signal path (219) on the bottom layer (202) of the printed circuit board (200);
placing an RF signal processing circuit (203) on the bottom layer (202);
mounting a shield (221) on the bottom layer (202) of the printed circuit board (200) to encompass the RF signal processing circuit (203), the ending of the signal wire (217) and the RF signal path (219).
